# EUROPÄISCHE PATENTSCHRIFT

(11) **EP 1 592 063 B1**
(45) Veröffentlichungstag und Bekanntmachung des Hinweises auf die Patenterteilung: **15.02.2012**
(21) Anmeldenummer: 05004622.6
(22) Anmeldetag: 03.03.2005
(51) Int. Cl.: H01L 23/48, H01L 23/40, H05K 1/14, H01L 25/16, H01L 25/07

(54) **Anordnung in Druckkontaktierung mit einem Leistungshalbleitermodul**
Assembly in pressure contact with a power semiconductor module
Assemblage en contact à pression avec un module semiconducteur de puissance

(30) Priorität: 29.04.2004 DE 102004021122
(43) Veröffentlichungstag der Anmeldung: 02.11.2005
(73) Patentinhaber: Semikron Elektronik GmbH & Co. KG Patentabteilung, 90431 Nürnberg (DE)
(72) Erfinder: Popp, Rainer, 91580 Petersaurach (DE); Lederer, Marco, 90453 Nürnberg (DE); Göbl, Christian, 90441 Nürnberg (DE); Stockmeier, Thomas, Dr., 90431 Nürnberg (DE)

(56) Entgegenhaltungen:
- EP-A- 1 128 432
- DE-A1- 10 064 194
- DE-A1- 19 533 298
- DE-C1- 10 231 219

## Beschreibung

Die Erfindung beschreibt eine Anordnung in Druckkontaktierung für äußerst kompakte Leistungshalbleitermodule. Moderne Ausgestaltungen derartiger Leistungshalbleitermodule mit hoher Leistung bezogen auf ihre Baugröße, die Ausgangspunkt dieser Erfindung sind, sind bekannt aus der DE 196 30 173 C2 oder der DE 199 24 993 C2.

Die DE 196 30 173 C2 offenbart ein Leistungshalbleitermodul zur direkten Montage auf einer Kühleinrichtung, bestehend aus einem Gehäuse und einem elektrisch isolierenden Substrat, welches seinerseits aus einem Isolierstoffkörper mit einer Mehrzahl darauf befindlicher gegeneinander isolierter metallischer Leiterbahnen und darauf befindlichen und mit diesen Verbindungsbahnen schaltungsgerecht verbundenen Leistungshalbleiterbauelementen besteht. Die externe elektrische Verbindung zu den Leiterbahnen einer außerhalb des Gehäuses angeordneten Leiterplatte erfolgt mittels Kontaktfedern.

Das Leistungshalbleitermodul weist weiterhin mindestens eine zentral angeordnete Ausnehmung zur Durchführung einer Schraubverbindung zu einem Kühlkörper auf. Diese dient zusammen mit einem auf der dem Leistungshalbleitermodul abgewandeten Seite der Leiterplatte angeordneten und auf dieser flächig aufliegenden, formstabilen Druckstück der Druckkontaktierung des Moduls. Diese Druckkontaktierung erfüllt gleichzeitig zwei Aufgaben: einerseits die sichere elektrische Kontaktierung der Anschlusselemente mit der Leiterplatte und andererseits die thermische Kontaktierung des Moduls mit dem Kühlkörper, wobei beide Kontaktierungen reversibel sind.

Nachteilig an den Leistungshalbleitermodulen nach dem bisher genannten Stand der Technik ist, dass das bekannte Druckstück eine Anordnung von weiteren Bauelementen, wie beispielhaft Widerständen, Kondensatoren oder integrierten Schaltungen auf dem von ihm überdeckten Teil der Leiterplatte nicht gestattet. Weiterhin nachteilig hierbei ist die mindestens eine Ausnehmung zur Durchführung einer Schraubverbindung. Dies schränkt den Platz für aktive Bauelemente im Inneren des Leistungshalbleitermoduls ein.

Beispielhaft aus der DE 199 24 993 C2 sind weiterhin Leistungshalbleitermodule bekannt, bei denen die Anschlüsse zwischen Leistungshalbleitermodul und einer Leiterplatte als Lötstifte ausgeführt sind. Diese Lötstifte dienen als Steuer- sowie als Lastanschlusselement der elektrischen Verbindung der Leistungshalbleiterbauelemente innerhalb des Leistungsmoduls mit den auf der Leiterplatte angeordneten Zuleitungen. Das Leistungshalbleitermodul kann somit entweder direkt oder, wie in der DE 199 24 993 offenbart, mittels einer Adapterplatine mit einer Leiterplatte verbunden werden. Der thermische Kontakt zwischen dem Leistungshalbleitermodul und einem Kühlkörper wird unabhängig von den elektrischen Kontaktierungen mittels Schraubverbindungen hergestellt.

Nachteilig an der Ausgestaltung derartiger Leistungshalbleitermodule ist, dass zwei unterschiedliche Verbindungstechniken (Schraub- und Lötverbindungen, die in mehreren Arbeitsschritten ausgeführt werden müssen) notwendig sind um das Modul in ein übergeordnetes Anordnung zu integrieren. Ein besonderer Nachteil besteht hierbei darin, dass die Kontaktsicherheit von Lötverbindungen über eine große Lebensdauer nicht gegeben ist.

Aus der DE 100 64 194 A1 ist weiterhin ein Leistungshalbleitermodul und ein Kühlkörper zur Aufnahme des Leistungshalbleitermoduls bekannt, wobei das Gehäuse des Leistungshalbleitermoduls eine Unter- und eine Oberseite aufweist. An der Oberseite ist wenigstens ein Federelement angeordnet, das ausgehend von der Oberseite aufragt und somit das Leistungshalbleitermodul bei Anordnung in der Aufnahme auf den Kühlkörper drückt.

Der vorliegenden Erfindung liegt die Aufgabe zu Grunde eine Anordnung mit einer Leiterplatte, einem Leistungshalbleitermodul und einer Kühleinrichtung vorzustellen, die einfach und kostengünstig herzustellen ist sowie äußerst kompakte Ausmaße aufweist.

Diese Aufgabe wird gelöst durch eine Anordnung nach dem Anspruch 1, spezielle Ausgestaltungen finden sich in den Unteransprüchen. Der Grundgedanke der Erfindung geht aus von einem Leistungshalbleitermodul zur direkten Montage auf einem Kühlkörper wobei das Leistungshalbleitermodul ein rahmenartiges isolierendes Kunststoffgehäuse aufweist. Dieses Kunststoffgehäuse weist weiterhin eine vorzugsweise einstückig mit dem Gehäuse verbundene erste Deckfläche auf. Die zweite Deckfläche wird gebildet durch ein Substrat, das aus einer Isolationsschicht und mindestens einer hierauf angeordnetem metallischen Schicht besteht, die dem Leistungshalbleitermodulinneren zugewandte ist. Diese metallische Schicht kann in sich strukturiert sein und bildet somit die mindestens eine Leiterbahn des Leistungshalbleitermoduls. Auf dieser/n Leiterbahnen ist mindestens ein Leistungshalbleiterbauelement angeordnet und mit einer weiteren Leiterbahn und / oder einem weiteren Leistungshalbleiterbauelement schaltungsgerecht verbunden.

Die erste Deckfläche des Gehäuses weist eine Mehrzahl von Ausnehmungen auf. Durch diese Ausnehmungen reichen Anschlusselemente zur elektrischen Verbindung der Leiterbahnen des Leistungshalbleitermoduls mit Kontaktpunkten der Leiterbahnen der oberhalb der ersten Deckfläche angeordneten Leiterplatte. Diese Leiterplatte aus einem isolierenden Substrat mit vorzugsweise zwei darauf oder darin angeordneten Leiterbahnen stellt die elektrischen Anschlüsse des Leistungshalbleitermoduls dar und trägt vorzugsweise weitere Bauelemente zur Steuerung des Leistungshalbleitermoduls.

Auf der zweiten Deckfläche, dem Substrat, ist auf der dem Leistungshalbleitermodulinneren abgewandten Seite eine vorzugsweise aktive Kühleinrichtung angeordnet. Aktive Kühleinrichtungen, beispielhaft ein Kühlkörper mit hieran angeordnetem Lüfter, weisen gegenüber passiven Kühleinrichtungen, beispielhaft einem Luftkühler, den wesentlichen Vorteil einer kompakteren Bauform auf.

Die Anschlusselemente sowohl für Last- als auch für Steueranschlüsse des Leistungshalbleitermoduls sind zumindest teilweise federnd gestaltete Anschlussleiter. Diese Anschlussleiter stellen die elektrische Verbindung der Verbindungsbahnen mit der außerhalb des Gehäuses angeordneten Leiterplatte und den darauf angeordneten externen Leiterbahnen her. Der sichere elektrische Kontakt zwischen den Anschlussleitern und den externen Leiterbahnen der Leiterplatte wird mittels einer weiter unten beschriebenen Anordnung zur Druckkontaktierung erzielt.

Bei einer erfindungsgemäßen Ausgestaltung der genannter Anordnung weist das Gehäuse des Leistungshalbleitermoduls in Richtung der Leiterplatte und / oder in Richtung der Kühleinrichtung Fortsätze zur Befestigung der einzelnen Komponenten der Anordnung zueinander auf.

Diese Fortsätze ragen in einer ersten Ausgestaltung durch Ausnehmungen der Leiterplatte, in einer zweiten Ausgestaltung durch Ausnehmungen der Kühleinrichtung hindurch. Bei der ersten Ausgestaltung beaufschlagt die Verbindung des Leistungshalbleitermoduls mit der Leiterplatte diese mit Druck um die Druckkontaktierung auszubilden. Prinzipiell sind zwei Arten der Befestigung möglich, eine reversible, bei der die einzelnen Komponenten ohne großen Aufwand wieder getrennt werden können, und eine irreversible, bei der die Komponenten derart mit einander verbunden sind, dass eine Trennung nur mit erhöhtem Aufwand möglich ist.

Eine mögliche Ausgestaltung der reversiblen Verbindung sind Schnapp- RastVerbindungen. Hierbei weisen die Fortsätze des Gehäuses Rastnasen und die Leiterplatte und / oder die Kühleinrichtung zugeordnete Widerlager auf.

Ein mögliche Ausgestaltung der irreversible Verbindung ist die Ausbildung der Fortsätze als Zapfen. Diese Zapfen durchdringen die zugeordneten Ausnehmungen der Leiterplatte und / oder der Kühleinrichtung und sind an ihrem Ende beispielhaft durch Ultraschall- oder thermische Einwirkung derartig verformt, dass sie eine Niete bilden, die sich auf einem zugeordneten Widerlager abstützt.

Vorzugsweise sind die Verbindungen des Leistungshalbleitermoduls mit der Leiterplatte und der Kühleinrichtung auf gleichartige Weise gebildet.

Bei einer weiteren erfindungsgemäßen Ausgestaltung der genannten Anordnung, die auch mit der erstgenannten kombiniert werden kann, weist die Kühleinrichtung Fortsätze auf. Diese Fortsätze reichen durch Ausnehmungen des Leistungshalbleitermoduls und / oder der Leiterplatte hindurch und bilden mit dieser / diesen eine reversible oder eine irreversible Verbindung der oben genannten Arten.

Eine weitere vorteilhafte Ausgestaltung einer oben genanten Anordnung mit einer Leiterplatte, einem Leistungshalbleitermodul und einer aktiven Kühleinrichtung weist mindestens ein Verbindungselement zur elektrischen Verbindung der aktiven Kühleinrichtung mit Leiterbahnen der Leiterplatte auf. Hierbei ist dieses Verbindungselement ein Teil des Gehäuses des Leistungshalbleitermoduls. Das Verbindungselement weist einen Steckkontakt zur elektrischen Verbindung mit der aktiven Kühleinrichtung, vorzugsweise dem dort angeordneten Lüfter, auf. Dieser Steckkontakt ist mit federnd ausgebildeten Kontaktelementen verbunden, wobei diese Kontaktelemente mit zugeordneten Kontaktflächen der Leiterbahnen der Leiterplatte verbunden sind.

Vorteilhaft an der erfindungsgemäßen Ausgestaltung der oben genannten Anordnung ist somit, dass sie einerseits den Vorteil einer Druckkontaktierung der elektrischen Verbindung zwischen dem Substrat des Leistungshalbleitermoduls und der Leiterplatte, die im Vergleich zu Lötverbindungen höhere Dauerbelastbarkeit besitzt aufweist. Andererseits weist diese Anordnung einen kompakten Aufbau auf, der demjenigen von löttechnischen Verbindungen zumindest ebenbürtig ist.

Die Erfindung wird anhand von Ausführungsbeispielen in Verbindung mit den Fig. 1 bis 3 näher erläutert.

Fig. 1 zeigt einen Schnitt durch eine erfindungsgemäße Anordnung.

Fig. 2 zeigt die erfindungsgemäßen Anordnung einer ersten dreidimensionale Explosionsdarstellung.

Fig. 3 zeigt die erfindungsgemäßen Anordnung einer zweiten dreidimensionale Explosionsdarstellung.

Fig. 4 zeigt einen Schnitt durch eine weitere erfindungsgemäße Anordnung.

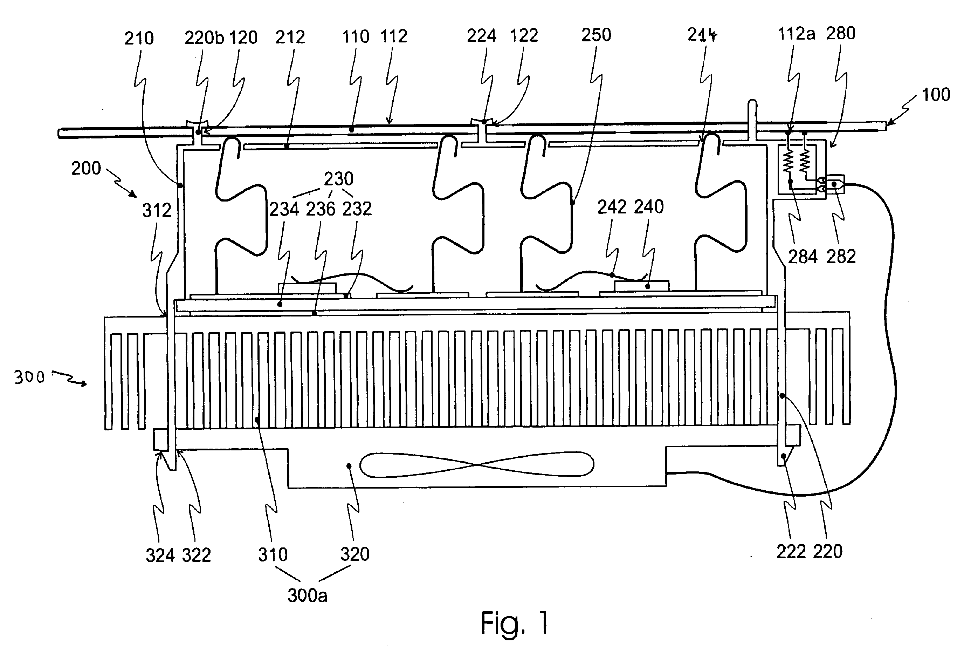

Fig. 1 zeigt einen Schnitt durch eine erfindungsgemäße Anordnung. Dargestellt ist eine Anordnung bestehend aus einer Leiterplatte (100), einem Leistungshalbleitermodul (200) sowie einer Kühleinrichtung (300).

Die Leiterplatte (100) weist einen Isolierstoffkörper (110) und auf und / oder innerhalb des Isolierstoffkörpers angeordnete Leiterbahnen (112) auf. Diese Leiterbahnen tragen eine Vielzahl von Signalen, wie beispielhaft die Last-, Steuer- und Hilfssignale des Leistungshalbleitermoduls (200).

Das Leistungshalbleitermodul (200) weist ein rahmenartiges Gehäuse (210) mit einstückig integriertem Deckel (212) auf. Die zweite Deckfläche des Gehäuses (210) wird durch das Substrat (230) gebildet. Das Substrat seinerseits besteht aus einem Isolierstoffkörper (234), vorzugsweise einer Industriekeramik wie Aluminiumoxid oder Aluminiumnitrit, sowie auf beiden Seiten dieses Isolierstoffkörpers metallischen Schichten (232, 236). Die metallischen Schichten sind hierbei mittels des bekannten DCB- Verfahrens auf dem Isolierstoffkörper (234) aufgebracht. Vorzugsweise ist die dem Inneren des Gehäuses zugewandete metallische Schichten (232) in sich strukturiert und bildet somit voneinander isolierte Leiterbahnen. Diese Leiterbahnen tragen Leistungshalbleiterbauelemente (240), wie IGBTs oder MOS-FETs, die hierauf mittels Lötverbindungen angeordnet sind. Weitere schaltungsgerechte Verbindungen der Leistungshalbleiterbauelemente (240) mit weiteren Leiterbahnen oder weiteren Leistungshalbleiterbauelementen erfolgen mittels Drahtbondverbindungen (242).

Die Verbindungselemente zur elektrischen Verbindung der Leiterbahnen (232) des Substrats (230) mit den externen Zuleitungen, gebildet aus den Leiterbahnen (112) der Leiterplatte (100), erfolgt mittels Kontaktfedern (250). Mittels der weiter unten beschriebenen Druckeinleitung werden diese Kontaktfedern (250) druckbeaufschlagt und bilden somit eine sichere elektrische Verbindung.

Die dargestellte Anordnung weist weiterhin eine Kühleinrichtung (300a) auf. Diese ist als aktive Kühleinrichtung (300a) bestehend aus einem Kühlkörper (310) und einem direkt damit verbundenen ungeregelten Ventilator (320) ausgebildet. Diese vorteilhafte, weil kleine und kompakte, Ausgestaltung kann je nach Anwendungszweck auch durch eine passive Kühleinrichtung ersetzt werden. Bei einer passiven Kühleinrichtung ohne Ventilator ist eine wassergekühlte Variante gegenüber einer luftgekühlten vorteilhaft.

Die Verbindung der Leiterplatte (100) und des Leistungshalbleitermoduls (200), die nicht nur der Anordnung zueinander sondern darüber hinaus auch der Druckeinleitung auf die Kontaktfedern (250) und somit zu einer Anordnung in Druckkontaktierung dient, wird ausgebildet durch eine Mehrzahl von Fortsätze (220) des Gehäuses (210) des Leistungshalbleitermoduls (200). Diese Fortsätze (220) können als reversible oder als irreversible Verbindungen ausgestaltet sein. Eine irreversible Verbindung wird gebildet durch als Zapfen ausgebildete Fortsätze (220b), die in den zugeordneten Ausnehmungen (120) der Leiterplatte (100) angeordnet sind und deren Enden derartig verformt sind, dass diese Verbindung eine Nietverbindung mit einem Widerlager (122) auf der Leiterplatte (100) darstellt. Diese Verformung kann beispielsweise durch thermische Einwirkung auf den Zapfen erfolgen. Als vorteilhaft hat sich eine Verformung durch Ultraschalleintrag erwiesen.

In ebensolcher Weise kann auch die Verbindung zwischen dem Leistungshalbleitermodul (200) und der Kühleinrichtung (300) als irreversible Verbindung ausgebildet sein. Dargestellt ist in Fig. 1 allerdings eine reversible Verbindung in der Ausgestaltung einer Schnapp- Rast- Verbindung. Hierbei sind die Fortsätze des Gehäuses (210) an ihren Enden als Rastnasen (222) ausgebildet. Die Fortsätze (220) reichen durch Ausnehmungen (312, 322) des Kühlkörpers (310) und des Lüfters (320), die die aktive Kühleinrichtung (300a) bilden, hindurch. Die Rastnasen (222) finden in den Widerlagern (324) der Kühleinrichtung (300a), hier des Lüfters (320), Halt.

Die Verbindung zwischen der Leiterplatte (100) und dem Leistungshalbleitermodul (200) kann selbstverständlich in ebensolcher Weise, wie für die Verbindung zwischen Leistungshalbleitermodul (200) und der Kühleinrichtung (300) gezeigt, ausgebildet sein.

Weiterhin dargestellt ist ein Verbindungselement (280) zur elektrischen Verbindung der aktiven Kühleinrichtung (300a) mit den Leiterbahnen (112a) der Leiterplatte (100). Das Verbindungselement (280) weist hierzu einen Steckkontakt (282) zur elektrischen Verbindung mit der aktiven Kühleinrichtung (300a) auf. Weiterhin ist dieser Steckkontakt (282) des Verbindungselements (280) mit federnd ausgebildeten Kontaktelementen (284) verbunden wobei diese Kontaktelemente (284) mit zugeordneten Kontaktflächen der Leiterbahnen (112a) der Leiterplatte (100) verbunden sind. Eine sichere elektrische Verbindung wird auch hier durch die oben genannte Druckbeaufschlagung erreicht. Mittels diese Verbindungselements ist eine einfach elektrische Verbindung der Leiterplatte (100) mit der Kühleinrichtung (300) möglich, ohne auf der Leiterplatte (100) zusätzliche Kontaktelemente, wie beispielhaft eine Stiftleiste, vorsehen zu müssen.

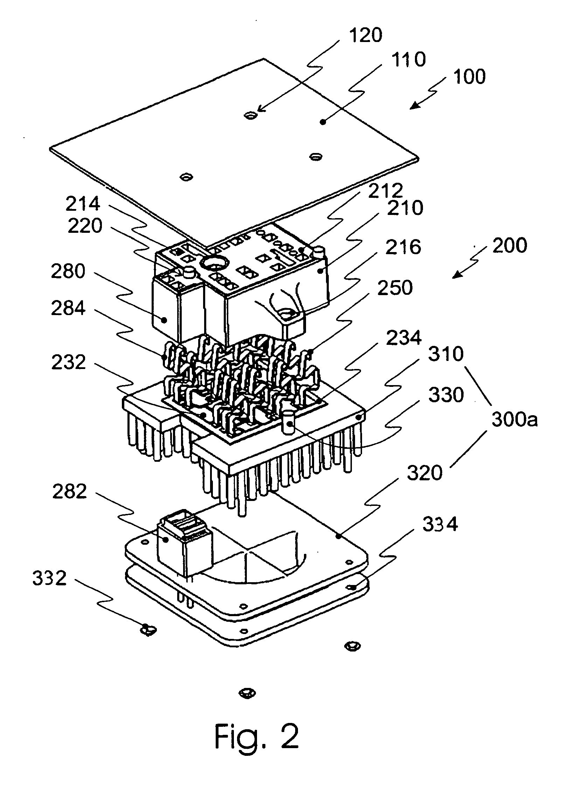

Fig. 2 zeigt die erfindungsgemäßen Anordnung einer ersten dreidimensionale Explosionsdarstellung. Dargestellt ist hier das isolierende Substrat (110) der Leiterplatte (100), wobei diese eine Mehrzahl von Ausnehmungen (120) aufweist. Weiterhin dargestellt ist das Leistungshalbleitermodul (200). Dessen Gehäuse (210) weist an seiner der Leiterplatte (100) zugewandten Deckfläche (212) ebenfalls Ausnehmungen (214) sowie Fortsätze (220) auf. Diese Fortsätze (220) des Gehäuses (210) reichen durch die Ausnehmungen (120) der Leiterplatte (100) hindurch um eine irreversible Verbindung zu schaffen.

Das Leistungshalbleitermodul (200) weist weiterhin ein Substrat (230) bestehend aus einem Isolierstoffkörper (234) und einer hierauf angeordneten metallischen Schichten (232) auf. Diese metallische Schicht ist in sich strukturiert und bildet hierdurch voneinander isolierte Leiterbahnen. Auf diesen Leiterbahnen (232) sind die Leistungshalbleiterbauelemente (nicht dargestellt) angeordnet. Die notwendigen schaltungsgerechten Verbindungen werden durch ebenfalls nicht dargestellte Drahtbondverbindungen hergestellt. Zur elektrischen Verbindung der Leistungshalbleiterbauelemente der Leiterbahn (232) dienen Kontaktfedern (250), die durch die Ausnehmungen (214) des Gehäuses (210) hindurchreichen. Durch die oben genannte irreversible Verbindung wird die Anordnung aus Leiterplatte (100) und Leistungshalbleitermodul (200) verbunden, und die Kontaktfedern (250) mit Druck beaufschlagt werden. Hierdurch wird die sichere elektrische Kontaktierung gewährleistet.

Weiterhin dargestellt ist die Kühleinrichtung (300a) bestehend aus einem Kühlkörper (310) und einem Ventilator (320). Diese beiden Teile werden ebenfalls durch Fortsätze, hier durch Fortsätze des Kühlkörpers die durch Ausnehmungen (334) des Ventilators (320) hindurchreichen mittels Arretiereinrichtungen (332) zueinander angeordnet. Das Substrat (230) des Leistungshalbleitermoduls (200) ist direkt auf dem Kühlkörper (300a) angeordnet um eine äußerst effektive Wärmeabfuhr zu gewährleisten.

Die Kühleinrichtung (300a) hier der Kühlkörper (310) weist weiterhin zwei Fortsätze (330) auf, die jeweils durch Ausnehmungen (216) eines Gehäuseteils (218) des Leistungshalbleitermoduls hindurchreichen. Auf diesen Fortsätzen werden sind Arretiereinrichtungen vergleichbar denjenigen (332), die die Kühleinrichtung (300) zueinander fixieren angeordnet und fixieren somit die Kühleinrichtung an dem Leistungshalbleitermodul.

Weiterhin dargestellt ist ein Verbindungselement (280), das an dem Gehäuse (210) des Leistungshalbleitermoduls (200) angeordnet ist. Dieses Verbindungselement besteht aus zwei Kontaktelementen (284), die ebenfalls als Federn ausgebildet sind somit über den Steckkontakt (282) der elektrischen Verbindung des Ventilators mit zugeordneten Leiterbahnen der Leiterplatte (100) dient. Über die Druckkontaktierung werden diese Kontaktelemente (284) hier ebenso wie oben dargestellt mit Druck beaufschlagt und bilden somit eine sichere elektrische Verbindung.

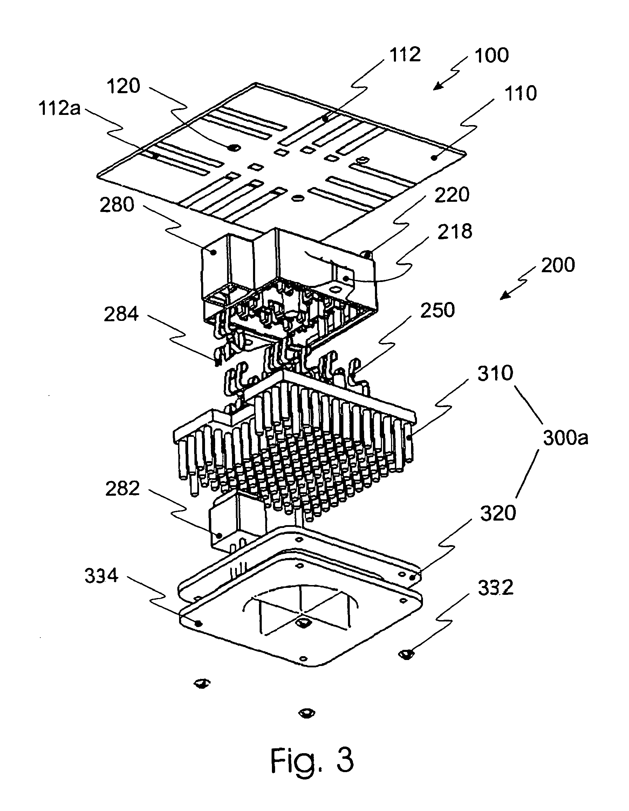

Fig. 3 zeigt die erfindungsgemäßen Anordnung einer zweiten dreidimensionale Explosionsdarstellung. Dargestellt ist die Leiterplatte (100) mit einer Mehrzahl von Leiterbahnen (112) auf ihrer Unterseite. Weiterhin sind die Ausnehmungen (120) der Leiterplatte (100) zur Aufnahme der Fortsätze (220) des Gehäuses (210) des Leistungshalbleitermoduls (200) zu erkennen.

Die elektrische Verbindung des Substrats (230) des Leistungshalbleitermoduls (200) erfolgt mittels Kontaktfedern (250). Das Gehäuse (210) des Leistungshalbleitermoduls (200) weist auf einer Seite ein Verbindungselement (280) auf, das einstückig mit dem Gehäuse (210) ausgestaltet ist. Kontaktfedern (284) identisch mit denen zur elektrischen Verbindung des Substrats (230) mit der Leiterplatte (100) dienen als Kontaktelemente (284) des Verbindungselements (280). Diese Kontaktelemente (284) verbinden Leiterbahnen (112a) der Leiterplatte (100) mit einem Steckkontakt (282) des Lüfters (320). Dieser Lüfter bildet zusammen mit dem Kühlkörper (310) die aktive Kühleinrichtung (300a) der erfindungsgemäßen Anordnung.

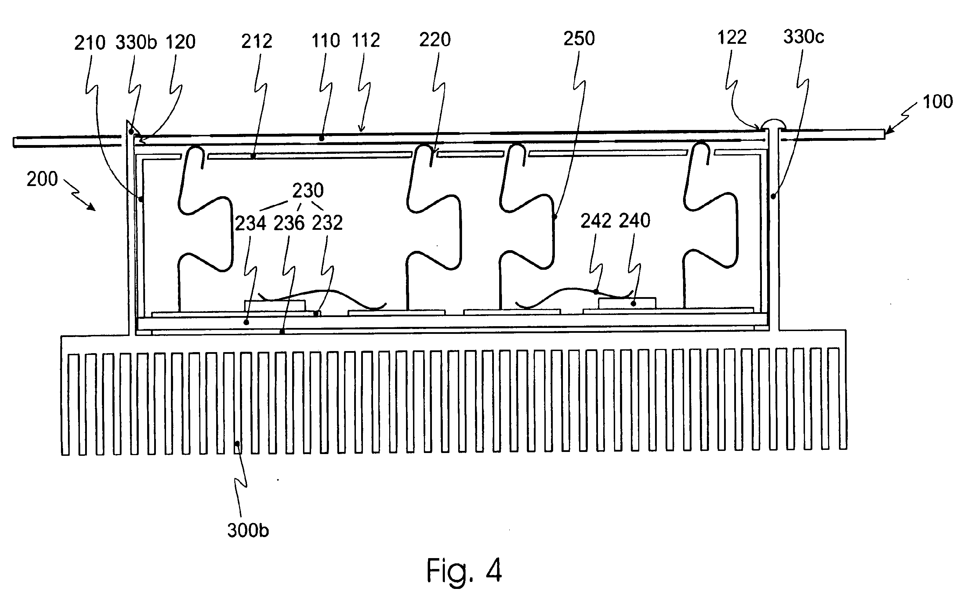

Fig. 4 zeigt einen Schnitt durch eine weitere erfindungsgemäße Anordnung. Dargestellt ist ebenfalls wie in Fig. 1 eine Anordnung bestehend aus einer Leiterplatte (100), einem Leistungshalbleitermodul (200) sowie einer Kühleinrichtung (300). Die Leiterplatte (100) ist hierbei analog zu derjenigen aus Fig. 1 ausgestaltet.

Das Leistungshalbleitermodul (200) weist ebenso ein rahmenartiges Gehäuse (210) mit einstückig integriertem Deckel (212) auf. Die zweite Deckfläche des Gehäuses (210) wird durch das Substrat (230) ebenfalls analog zu Fig. 1 gebildet. Die Anordnung weist weiterhin eine passive Kühleinrichtung (300b) auf.

Die Verbindung der Anordnung aus Leiterplatte (100), Leistungshalbleitermodul (200) und Kühleinrichtung (300b), die auch zur Druckeinleitung auf die Kontaktfedern (250) und somit zu einer Anordnung in Druckkontaktierung dient, wird ausgebildet durch eine Mehrzahl von Fortsätzen (330) des aus Aluminium bestehenden Kühlbauteils (300b). Diese Fortsätze (330) können als reversible oder als irreversible Verbindungen ausgestaltet sein. Eine irreversible Verbindung wird gebildet durch als Zapfen ausgebildete Fortsätze (330c), die in den zugeordneten Ausnehmungen (120) der Leiterplatte (100) angeordnet sind und deren Enden derartig verformt sind, dass diese Verbindung eine Nietverbindung mit einem Widerlager (122) auf der Leiterplatte (100) darstellt. Diese Verformung kann beispielsweise durch mechanische Einwirkung auf den Zapfen erfolgen.

Die Ausgestaltung des Fortsatzes (330b) als reversible Verbindung ist als bekannte und bereits oben beschriebene Schnapp- Rast- Verbindung ausgebildet.

## Patentansprüche

1. Anordnung in Druckkontaktierung mit einer Leiterplatte (100), einem Leistungshalbleitermodul (200) und einer Kühleinrichtung (300), wobei die Leiterplatte (100) einen Isolierstoffkörper (110) mit darauf und / oder darin angeordneten Leiterbahnen (112) aufweist, wobei das Leistungshalbleitermodul (200) ein rahmenartiges isolierendes Kunststoffgehäuse (210) mit einer ersten Ausnehmungen (214) aufweisenden Deckfläche (212), ein die zweite Deckfläche des Gehäuses (210) bildendes Substrat (230) mit mindestens einer Leiterbahn (232) und mindestens einem hierauf angeordneten und schaltungsgerecht verbundenen Leistungshalbleiterbauelement (240) sowie Kontaktfedern (250), die durch die Ausnehmungen (214) des Gehäuses (210) hindurchreichen, zur Verbindung der Leiterbahn (232) des Substrats (230) mit Kontaktstellen der Leiterbahnen (112) der Leiterplatte (100) aufweist, und die Kühleinrichtung (300) aktiv oder passiv ist, wobei entweder das Gehäuse (210) des Leistungshalbleitermoduls (200) in Richtung der Leiterplatte (100) Fortsätze (220b) aufweist, die durch Ausnehmungen (120) der Leiterplatte (100) hindurchragen und in Richtung der Kühleinrichtung (300) andere Fortsätze (220) aufweist, die durch Ausnehmungen (312, 322) hindurchragen der Kühleinrichtung (300) hindurchragen,
oder die Kühleinrichtung (300) Fortsätze (330b, 330c) aufweist, die durch Ausnehmungen (120) der Leiterplatte (100) hindurchragen,
oder das Gehäuse (210) des Leistungshalbleitermoduls (200) in Richtung der Leiterplatte (100) Fortsätze (220) aufweist, die durch Ausnehmungen (120) der Leiterplatte (100) hindurchragen und die Kühleinrichtung (300) Fortsätze (330) aufweist, die durch Ausnehmungen (216) des Gehäuses (200) hindurchragen,
wobei die jeweiligen Fortsätze somit reversible oder irreversible Verbindungen ausbilden und
wobei die jeweiligen Fortsätze, die die Leiterplatte (100) durchdringen diese überragen und mit Druck beaufschlagen.

2. Anordnung nach Anspruch 1,
wobei die reversible Verbindung gebildet wird durch als Rastnasen (222) ausgebildete Fortsätze (220, 330), die durch die Ausnehmungen (120, 216, 312, 322) hindurchragen und deren Rastnasen (222) in zugeordneten Widerlagern (122, 324) der Leiterplatte (100), des Gehäuses (210) oder des Kühlkörpers (300) angeordnet sind und eine Schnapp- Rast- Verbindung darstellen.

3. Anordnung nach Anspruch 1,
wobei die reversible Verbindung gebildet wird durch als Zapfen ausgebildete Fortsätze (220, 330), die durch die Ausnehmungen (120, 216, 312, 322) hindurchragen und die durch Arretiereinrichtungen in zugeordneten Widerlagern (122, 324) der Leiterplatte (100), des Gehäuses (210) oder des Kühlkörpers (300) angeordnet sind.

4. Anordnung nach Anspruch 1,
wobei die irreversible Verbindung gebildet wird durch als Zapfen ausgebildete Fortsätze (220, 330), die in den zugeordneten Ausnehmungen (120, 216, 312, 322) angeordnet sind und deren Enden derartig verformt sind, dass diese eine Nietverbindung darstellt.

5. Anordnung nach Anspruch 1,
wobei eine passive Kühleinrichtung (300) als Luft- oder Wasserkühler ausgebildet ist.

6. Anordnung nach Anspruch 1,
wobei eine aktive Kühleinrichtung (300a) einen ungeregelten oder einen temperaturgeregelten Lüfter (320) aufweist.

7. Anordnung in Druckkontaktierung gemäß Anspruch 1 mit einer Leiterplatte (100), einem Leistungshalbleitermodul (200) und einer aktiven Kühleinrichtung (300a), wobei das Gehäuse (210) des Leistungshalbleitermodul (200) mindestens ein Verbindungselement (280) zur elektrischen Verbindung der aktiven Kühleinrichtung (300a) mit Leiterbahnen (112) der Leiterplatte (100) aufweist,
wobei das Verbindungselement (280) einen Steckkontakt (282) zur elektrischen Verbindung mit der aktiven Kühleinrichtung (300a) aufweist, dieser Steckkontakt (282) mit federnd ausgebildeten Kontaktelementen (284) verbunden ist und diese Kontaktelemente (284) mit zugeordneten Kontaktflächen der Leiterbahnen (112a) der Leiterplatte (100) verbunden sind.

## Claims

1. An arrangement in pressure contact with a printed circuit board (100), a power semiconductor module (200), and a cooling device (300), wherein
the printed circuit board (100) has a body of insulation material (110) and conducting tracks (112) arranged thereon and/or therein, wherein
the power semiconductor module (200) has an insulating plastic housing (210) in the form of a frame, with a first cover surface (212) having openings (214), a substrate (230) forming the second cover surface of the housing (210) with at least one conducting track (232) and at least one power semiconductor component (240) arranged thereon and connected in accordance with the circuit in question, and also contact springs (250), which pass through the openings (214) of the housing (210), for purposes of connecting the conducting track (232) of the substrate (230) with contact points on the conducting tracks (112) of the printed circuit board (100), and the cooling device (300) is active or passive, wherein
either the housing (210) of the power semiconductor module (200) has extensions (220b) in the direction of the printed circuit board (100), which project through openings (120) in the printed circuit board (100), and has other extensions (220) in the direction of the cooling device (300), which project through openings (312, 322) in the cooling device (300), or the cooling device (300) has extensions (330b, 330c) which project through openings (120) in the printed circuit board (100),
or the housing (210) of the power semiconductor module (200) has extensions (220) in the direction of the printed circuit board (100), which project through openings (120) in the printed circuit board (100), and the cooling device (300) has extensions (330) which project through openings (216) in the housing (200), wherein
the respective extensions thus form reversible or irreversible connections, and wherein
the respective extensions, which penetrate the printed circuit board, project above the latter and apply pressure to the latter.

2. The arrangement in accordance with Claim 1, wherein
the reversible connection is formed by extensions (220, 330) designed as latching tongues (222), which project through the openings (120, 216, 312, 322) and whose latching tongues are arranged on associated bearing surfaces (122, 324) of the printed circuit board (100), of the housing (210), or of the cooling body (300), and represent a snap-on latching connection.

3. The arrangement in accordance with Claim 1, wherein
the reversible connection is formed by extensions (220, 330) designed as pins (222), which project through the openings (120, 216, 312, 322) and which are arranged by means of locking devices on associated bearing surfaces (122, 324) of the printed circuit board (100), of the housing (210), or of the cooling body (300).

4. The arrangement in accordance with Claim 1, wherein the irreversible connection is formed by extensions (220, 330) designed as pins, which are arranged in the associated openings (120, 216, 312, 322) and whose ends are deformed such that these represent a riveted joint.

5. The arrangement in accordance with Claim 1, wherein
a passive cooling device (300) is designed as an air cooler or water cooler.

6. The arrangement in accordance with Claim 1, wherein
an active cooling device (300a) has an unregulated or a temperature-regulated fan (320).

7. An arrangement in pressure contact in accordance with Claim 1, with a printed circuit board (100), a power semiconductor module (200), and an active cooling device (300a), wherein
the housing (210) of the power semiconductor module (200) has at least one connecting element (280) to provide an electrical connection between the active cooling device (300a) and conducting tracks (12) of the printed circuit board (100), wherein
the connecting element (280) has a plug-in contact (282) to provide an electrical connection with the active cooling device (300a), this plug-in contact (282) is connected with contact elements (284) of sprung design, and these contact elements (284) are connected with associated contact surfaces of the conducting tracks (112a) of the printed circuit board (100).

## Revendications

1. Agencement dans une mise en contact par pression comportant une carte imprimée (100), un module à semi-conducteurs de puissance (200) et un dispositif de refroidissement (300), la carte imprimée (100) présentant un corps isolant (110) réalisé avec des pistes conductrices (112) disposées dessus et/ou à l'intérieur, le module à semi-conducteurs de puissance (200) présentant un boîtier plastique (210) isolant de type cadre avec une première surface de recouvrement (212) présentant des évidements (214), un substrat (230) formant la seconde surface de recouvrement du boîtier (210) avec au moins une piste conductrice (232) et au moins un composant à semi-conducteurs de puissance (240) disposé dessus et relié de façon conforme au circuit, ainsi que des ressorts de contact (250), qui passent à travers les évidements (214) du boîtier (210), pour la liaison de la piste conductrice (232) du substrat (230) avec des points de contact des pistes conductrices (112) de la carte à circuits imprimés (100), et le dispositif de refroidissement (300) étant actif ou passif,
dans lequel soit le boîtier (210) du module à semi-conducteurs de puissance (200) présente en direction de la carte à circuits imprimés (100) des appendices (220b), lesquels passent à travers des évidements (120) de la carte à circuits imprimés (100), et présente en direction du dispositif de refroidissement (300) d'autres appendices (220), lesquels passent à travers des évidements (312, 322), soit le dispositif de refroidissement (300) présente des appendices (330b, 330c), qui passent à travers des évidements (120) de la carte à circuits imprimés (100),
soit le boîtier (210) du module à semi-conducteurs de puissance (200) présente en direction de la carte à circuits imprimés (100) des appendices (220), qui passent à travers des évidements (120) de la carte à circuits imprimés (100), et le dispositif de refroidissement (300) présente des appendices (330), qui passent à travers des évidements (216) du boîtier (200),
les appendices respectifs formant ainsi des liaisons réversibles ou irréversibles et
les appendices respectifs, qui pénètrent la carte à circuits imprimés (100), dépassant de celle-ci et la sollicitant avec pression.

2. Agencement selon la revendication 1,
dans lequel la liaison réversible est formée par des appendices (220, 330) conçus comme des ergots d'encliquetage (222), lesquels passent à travers les évidements (120, 216, 312, 322) et dont les ergots d'encliquetage (222) sont disposés dans des paliers de butée (122, 324) associés de la carte à circuits imprimés (100), du boîtier (210) ou du corps de refroidissement (300) et représentent une liaison à encliquetage et blocage.

3. Agencement selon la revendication 1,
dans lequel la liaison réversible est formée par des appendices (220, 330) conçus comme des tenons, lesquels passent à travers les évidements (120, 216, 312, 322) et lesquels sont disposés à travers des dispositifs d'arrêt dans des paliers de butée (122, 324) associés de la carte à circuits imprimés (100), du boîtier (210) ou du corps de refroidissement (300).

4. Agencement selon la revendication 1,
dans lequel la liaison irréversible est formée par des appendices (220, 330) conçus comme des tenons, lesquels sont disposés dans les évidements (120, 216, 312, 322) associés et dont les extrémités sont déformées, de telle sorte que ceci représente une liaison à rivet.

5. Agencement selon la revendication 1,
dans lequel un dispositif de refroidissement (300) passif est conçu comme refroidisseur à air ou refroidisseur à eau.

6. Agencement selon la revendication 1,
dans lequel un dispositif de refroidissement actif (300a) présente un aérateur (320) non régulé ou un aérateur régulé au niveau de la température.

7. Agencement dans une mise en contact par pression selon la revendication 1, comprenant une carte à circuits imprimés (100), un module à semi-conducteurs de puissance (200) et un dispositif de refroidissement (300a) actif, le boîtier (210) du module à semi-conducteurs de puissance (200) présentant au moins un élément de liaison (280) pour la liaison électrique du dispositif de refroidissement (300a) actif avec des pistes conductrices (112) de la carte à circuits imprimés (100),
dans lequel l'élément de liaison (280) présente un contact à enfichage (282) pour la liaison électrique avec le dispositif de refroidissement actif (300a), ce contact à enfichage (282) est relié à des éléments de contact (284) formés de façon élastique et ces éléments de contact (284) sont reliés à des surfaces de contact associées des pistes conductrices (112a) de la carte à circuits imprimés (100).
